Europäisches Patentamt

European Patent Office

Office européen des brevets

(11) Publication number: **0 615 284 A2**

(12) **EUROPEAN PATENT APPLICATION**

(21) Application number: **94103804.4**

(22) Date of filing: **11.03.94**

(51) Int. Cl.5: **H01L  21/60,** H01L 21/603

(30) Priority: **11.03.93 JP 51119/93**
**01.09.93 JP 216805/93**
**20.09.93 JP 232871/93**

(43) Date of publication of application:
**14.09.94 Bulletin  94/37**

(84) Designated Contracting States:
**DE FR GB**

(71) Applicant: **Kabushiki Kaisha Toshiba**
**72, Horikawa-cho**
**Saiwai-ku**
**Kawasaki-shi (JP)**

(72) Inventor: **Mori, Miki, c/o Intellectual Property
Div.**
**K.K. TOSHIBA,**
**1-1 Shibaura 1-chome,**
**Minato-ku**
**Tokyo 105 (JP)**
Inventor: **Kizaki, Yukio, c/o Intellectual**
**Property Div.**
**K.K. TOSHIBA,**
**1-1 Shibaura 1-chome,**
**Minato-ku**
**Tokyo 105 (JP)**
Inventor: **Yasumoto, Takaaki, c/o Intellectual**
**Property Div.**
**K.K. TOSHIBA,**
**1-1 Shibaura 1-chome,**
**Minato-ku**
**Tokyo 105 (JP)**
Inventor: **Yamakawa, Koji, c/o Intellectual**
**Property Div.**

**K.K. TOSHIBA,**
**1-1 Shibaura 1-chome,**
**Minato-ku**
**Tokyo 105 (JP)**
Inventor: **Saito, Masayuki, c/o Intellectual**
**Property Div.**
**K.K. TOSHIBA,**
**1-1 Shibaura 1-chome,**
**Minato-ku**
**Tokyo 105 (JP)**
Inventor: **Uchida, Tatsuro, c/o Intellectual**
**Property Div.**
**K.K. TOSHIBA,**
**1-1 Shibaura 1-chome,**
**Minato-ku**
**Tokyo 105 (JP)**
Inventor: **Togasaki, Takasi, c/o Intellectual**
**Property Div.**
**K.K. TOSHIBA,**
**1-1 Shibaura 1-chome,**
**Minato-ku**
**Tokyo 105 (JP)**
Inventor: **Yebisuya, Takashi, c/o Intellectual**
**Property Div.**
**K.K. TOSHIBA,**
**1-1 Shibaura 1-chome,**
**Minato-ku**
**Tokyo 105 (JP)**

(74) Representative: **Henkel, Feiler, Hänzel &
Partner**
**Möhlstrasse 37**
**D-81675 München (DE)**

(54) **Electronic circuit device.**

(57) An electronic circuit device includes a substrate (513), a wiring layer (514) formed on the surface of the substrate (513), a bump (512) formed on the wiring layer (514), and a micro electronic element (511) formed on the bump (512), wherein solid-phase diffusion bonding is performed at least between the wiring layer (514) and the bump (512) or between the bump (514) and the micro electronic element (511).

Rank Xerox (UK) Business Services
(3.10/3.09/3.3.4)

511

512

514

513

F I G. 5

The present invention relates to an electronic circuit device such as a semiconductor device or a liquid crystal display device and, more particularly, to an improvement of bonding between a passive chip element and a substrate.

In recent years, to obtain a more compact, light-weight electronic circuit device, a method of mounting semiconductor elements and passive chip elements at a higher density to obtain a low-profile structure is proposed. Main conventional mounting methods are so-called wire-bonding mounting for placing a semiconductor element on a mounting substrate and electrically connecting the semiconductor element to the substrate through wires, fillet mounting for mounting a compact component on a mounting substrate, and the like.

A facedown mounting technique for forming bumps on a semiconductor element and connecting this element to a substrate through these bumps to mount the element is recently developed in place of the conventional mounting methods.

This facedown mounting technique has a higher manufacturing efficiency than that of wire-bonding mounting because the bonding operations can be performed at once. An example of the electronic circuit device obtained by this facedown mounting technique will be described below.

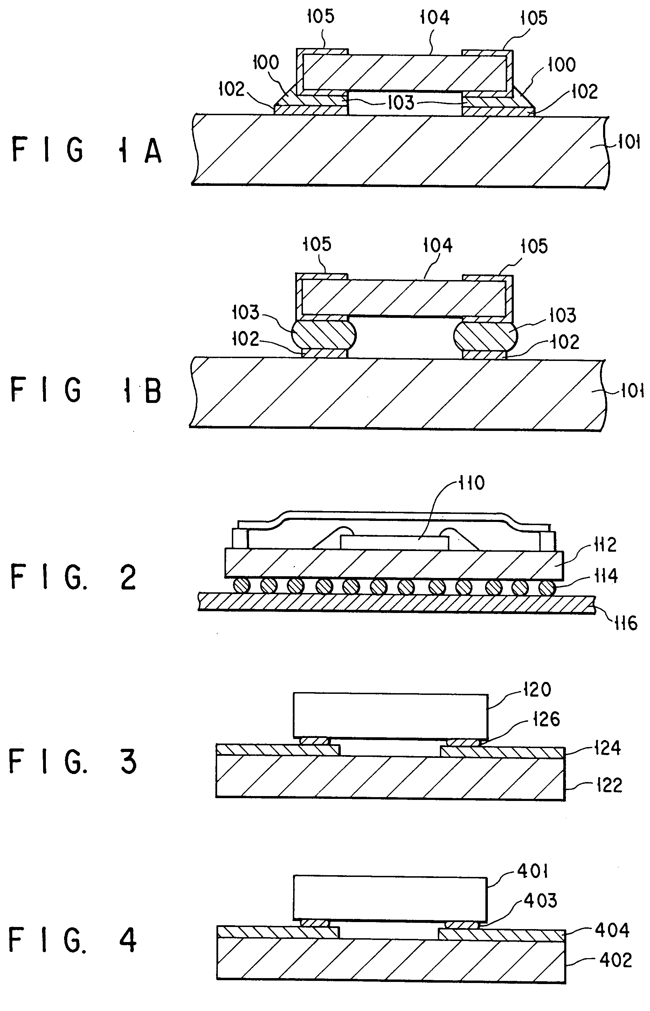

For example, FIG. 1A is a view for explaining fillet mounting, and FIG. 1B is a view for explaining bump mounting.

A passive chip element 104 is mounted on electrodes 102 on a substrate 101 through soldered portions 103. Reference numerals 105 denote electrodes of the passive chip element. Bump mounting can achieve high-density mounting due to the absence of fillets 100 extending outward from the passive chip element 104.

FIG. 2 is a schematic view of an electronic circuit device obtained when a package incorporating a semiconductor device is mounted in a ball grid array structure. As shown in FIG. 2, there is a ball grid array for connecting a ceramic substrate 112 having, e.g., a semiconductor element 110 thereon, to a substrate 116 through solder bumps 114.

A facedown mounting technique for forming bumps on a semiconductor element to mount it on a substrate is developed in place of a so-called semiconductor package obtained by resin-molding a semiconductor device. In particular, the developments of mounting techniques for flip chips have advanced. FIG. 3 is a view for explaining this flip-chip mounting technique. In flip chip mounting, as shown in FIG. 3, solder bumps 126 formed on a semiconductor element are reflowed to electrically and mechanically connect a semiconductor element 120 to wiring layers 124 on a substrate 122.

By all these methods, a solder is used as a connecting material and is melted to connect the passive chip element, the package, and the semiconductor element to the corresponding substrates.

A method of melting the solder may cause short-circuiting between adjacent elements due to the spread of the solder. For this reason, care must be taken for design of distances between the adjacent electrodes and between the passive chip elements, thereby avoiding a higher density.

In a liquid crystal display, a COG (Chip On Glass) mounting technique for mounting a chip on a glass substrate is available. In this liquid crystal display element, the chip faces down and is bonded on the glass substrate using bumps of chip. In general, the bumps are used to electrically connect the semiconductor element to a wiring layer formed on the glass substrate, and a resin is used to mechanically connect the semiconductor element to the glass substrate. One COG mounting technique is shown in FIG. 4. As shown in FIG. 4, a technique for performing initial connections is also proposed. Solder bumps 403 having a low melting point and a low hardness and formed on a semiconductor element 401 are brought into tight contact with wiring layers 404 formed on a substrate 402 to perform the initial connections without being through a connection resin. According to this method, the mechanical strength is low, and resin sealing is finally performed to assure the device reliability (Jpn. Pat. Appln. KOKAI Publication No. 3-108734). When the wiring layer on the substrate consists of a metal (e.g., aluminum) which tends to form a rigid oxide film, the wiring surface is covered with the oxide film at the time of connections. Although the connection between the wiring layer and the substrate is interrupted by the oxide film, this oxide film cannot be perfectly destroyed to degrade the connection reliability.

As a method of perfectly destroying an oxide film, a method of connecting a bump to an aluminum wiring layer through an anisotropic conductive film including fine conductive grains is available. According to this method, although the fine conductive grains are used to destroy the aluminum oxide film to connect the aluminum wiring layer to the bump, the fine conductive grains are used to perform only electrical connection and therefore has a small allowable current value and a high connection resistance. In addition precise connecting cannot be performed due to contact among the fine conductive grains. In this COG mounting, since electrical connection is achieved during hardening the resin, this makes it difficult to repair the resultant device if a defect is present.

On the other hand, a method of forming a solder bump, melting the solder bump, and alloying it with the wiring layer on a substrate to achieve electrical connection is available as in flip-chip mounting. When a wiring layer consists of a metal such as aluminum having poor wettability with a solder, satisfactory connection cannot be achieved.

As described above, the conventional methods have failed to obtain an electronic circuit device having a sufficiently electrical connection and a high allowable current density.

Conventional mounting of an electronic circuit device uses a solder which is then melted to achieve electrical connection. For this reason, when the solder is melted and bonded, the solder may be deformed and spreaded to cause short-circuiting between the adjacent electrodes. For this reason, the distance between the adjacent electrodes and the distance between the passive chip elements or semiconductor elements must be designed with a sufficient margin in consideration of the spread of the solder, thereby avoiding a higher density.

It is an object of the present invention to provide an improved structure mounted with an electronic circuit device, wherein substrates are respectively connected to a passive chip element, a package, and a semiconductor element using a bump-like bonding means at a high density to obtain a high connection strength, a high allowable current density, a low and constant connection resistance, and highly reliable connection.

According to the first embodiment of the present invention, there is provided an electronic circuit device comprising:

a substrate;

a wiring layer formed on a surface of the substrate;

bump-like bonding means formed on the wiring layer; and

a micro electronic element formed on the bonding means,

wherein solid-phase diffusion bonding is performed either between the wiring layer and the bonding means or between the bonding means and an electrode of the micro electronic element.

The second embodiment of the present invention is a preferable example of the first embodiment and provides a semiconductor device comprising:

an insulating substrate;

a wiring layer formed on the insulating substrate;

bump-like bonding means bonded to a surface of the wiring layer by solid-phase diffusion; and

a semiconductor element formed on the bonding means.

The third embodiment of the present invention is another preferable example of the first embodiment and provides a liquid crystal display device comprising:

a pair of substrates;

a liquid crystal sandwiched between the pair of substrates;

a wiring layer formed on one of the pair of substrates and having a thickness of 3,000Å to 8,500Å, the wiring layer including a top layer having a thickness of 2,500Å to 8,000Å and containing aluminum as a main component;

bump-like bonding means bonded on the top layer by solid-phase diffusion; and

a semiconductor element formed on the bonding means.

According to the fourth embodiment of the present invention, there is also provided a circuit substrate comprising a substrate, and a multilayered wiring layer constituted by a first metal layer formed on the substrate, an oxide film formed on the first metal layer and consisting essentially of oxygen and the same metal as that of the first metal layer, and a second metal layer formed on the metal oxide film and consisting of the same metal as that of the first metal layer.

The multilayered layer can be used in a variety of applications as wiring layers used in the first to third embodiments.

In addition, according to the fifth embodiment of the present invention, there is provided a circuit substrate comprising a substrate, a wiring pattern formed on the substrate, and first and second pad arrays formed on the wiring pattern,

wherein the first and second pad arrays are defined such that a central coordinate position of the second pad array is defined as $(x_i + j, y_i + k)$ ($i$ = 1 to n; $j$ and $k$ are moving distances) when a central coordinate position of the first pad array is defined as $(x_i, y_i)$ ($i$ = 1 to n).

This wiring layer can also be used in a variety of applications as the wiring layers of the first to third embodiments.

According to the first to third embodiments of the present invention, bumps are used to perform bonding at once. According to the present invention, solid-phase diffusion bonding is applied to at least between the wiring layer and the bonding means or between the bonding means and the electrode of the

4

micro electronic element. Unlike the solder, a material used in this bonding can provide a high connection strength, a high allowable current density, a low and constant connection resistance, and highly reliable connection. As described above, according to the present invention, the bump is combined with solid-state diffusion bonding to achieve the above object.

According to the fourth and fifth embodiments of the present invention, if a mounted element should become a defective element during the manufacturing process of each electronic circuit device described above, the repairing operation for replacing the defective element with another nondefective element can be facilitated to achieve highly reliable connection.

This invention can be more fully understood from the following detailed description when taken in conjunction with the accompanying drawings, in which:

FIG. 1A is a schematic view showing a conventional electronic circuit device;

FIG. 1B is a schematic view showing another conventional electronic circuit device;

FIG. 2 is a schematic view showing still another conventional electronic circuit device;

FIG. 3 is a schematic view showing still another conventional electronic circuit device;

FIG. 4 is a view for explaining a conventional liquid crystal display device;

FIG. 5 is a sectional view showing part of an electronic circuit device according to the first embodiment of the present invention;

FIGS. 6A to 6C are views showing the steps in manufacturing the electronic circuit device shown in FIG. 5;

FIG. 7 is a graph showing the shear strengths of a chip and a substrate as a function of chip temperature;

FIG. 8 is a graph showing the connection resistance as a function of the bump/wire material;

FIG. 9 is a graph showing high-temperature, high-humidity test results;

FIG. 10 is a graph showing TST results;

FIG. 11 is a view showing another example of the first embodiment of the present invention;

FIG. 12 is a view showing another example of the first embodiment of the present invention;

FIG. 13 is a view showing a relationship between the resistor portion of a printing head and a wiring layer;

FIG. 14 is a view showing another relationship between the resistor portion of the printing head and a wiring layer;

FIG. 15 is a view showing a semiconductor device according to the second embodiment of the present invention;

FIGS. 16A to 16C are views showing the steps in manufacturing the semiconductor device according to the second embodiment of the present invention;

FIG. 17 is a view showing another semiconductor device according to the second embodiment of the present invention;

FIGS. 18A and 18B are views for explaining the steps in manufacturing a wiring substrate used in still another example of the second embodiment of the present invention;

FIGS. 19A to 19C are views for explaining the process of forming a bump;

FIG. 20 is a view showing a state in which the bump of the second embodiment of the present invention is bonded to a wiring pattern;

FIG. 21 is a schematic view showing a liquid crystal display device according to the third embodiment of the present invention;

FIG. 22 is a graph showing the relationship between a wiring film thickness and a reverse area ratio in the liquid crystal display device according to the third embodiment of the present invention;

FIG. 23 is a side view a state in which a semiconductor element is mounted on a circuit substrate as an example of the fourth embodiment of the present invention;

FIG. 24 is a plan view of FIG. 23;

FIG. 25 is a side view showing a state in which a semiconductor element is mounted on a circuit substrate as another example of the fourth embodiment of the present invention;

FIGS. 26A to 26E are schematic views showing an example of the fifth embodiment of the present invention;

FIGS. 27A and 27B are views for explaining an example of the fifth embodiment of the present invention; and

FIGS. 28A and 28B are views for explaining another example of the fifth embodiment of the present invention.

The present invention mainly has five embodiments.

5

According to each of the first and third embodiments of the present invention, there is provided an electronic circuit device in which solid-phase diffusion bonding is performed at least between a wiring layer and a bump-like bonding means or between the bump-like bonding means and, e.g., a passive chip element, a package incorporating a semiconductor element, or the electrode of a micro electronic element such as a semiconductor element or a liquid crystal display element, and thermal printing head element.

According to each of the fourth and fifth embodiments, a circuit substrate having a multilayered wiring layer can be obtained. This circuit substrate facilitates a repairing operation during its manufacturing process to improve productivity and achieve highly reliable connection.

The techniques of the fourth and fifth embodiments can be preferably applied to the first to third embodiments.

According to the first embodiment, there is provided an electronic circuit device comprising:

a substrate;

a wiring layer formed on a surface of the substrate;

bump-like bonding means formed on the wiring layer; and

a micro electronic element formed on the bonding means,

wherein solid-phase diffusion bonding is performed either between the wiring layer and the bonding means or between the bonding means and an electrode of the micro electronic element.

According to the present invention, solid-phase diffusion bonding is defined such that both a metal A and a metal B are heated to temperatures below their melting points, and one of the metals in a solid-phase state is diffused in the other metal and bonded thereto, or that the metals in the solid-phase state are diffused to each other to achieve bonding. For example, solid-phase diffusion bonding produces an intermetallic compound, a solid solution, or a eutectic alloy. At this time, when the metals A and B are bonded to each other under pressure during heating, even if an oxide film is formed on the metal A or B, the oxide film can be destroyed to allow rigid bonding. For example, a bump consists of gold and a wiring layer consists of aluminum, an intermetallic compound of gold and aluminum is formed. When the wiring layer consists of copper, a solid solution of gold and copper is formed. When the wiring layer consists of tin, a eutectic alloy of gold and tin is formed.

When metals to be bonded are metals A, diffusion occurs between the metals A at a temperature below the melting point of the metal A, thereby achieving bonding.

Unlike bonding using a solder, i.e., an In-Sn alloy as the bonding means with having the deformation as greater as 80 - 90%, the bonding means in "solid-phase diffusion" bonding is not melted, or the bonding means is not greatly deformed due to this melting.

The first embodiment of the present invention will be described with reference to the accompanying drawings.

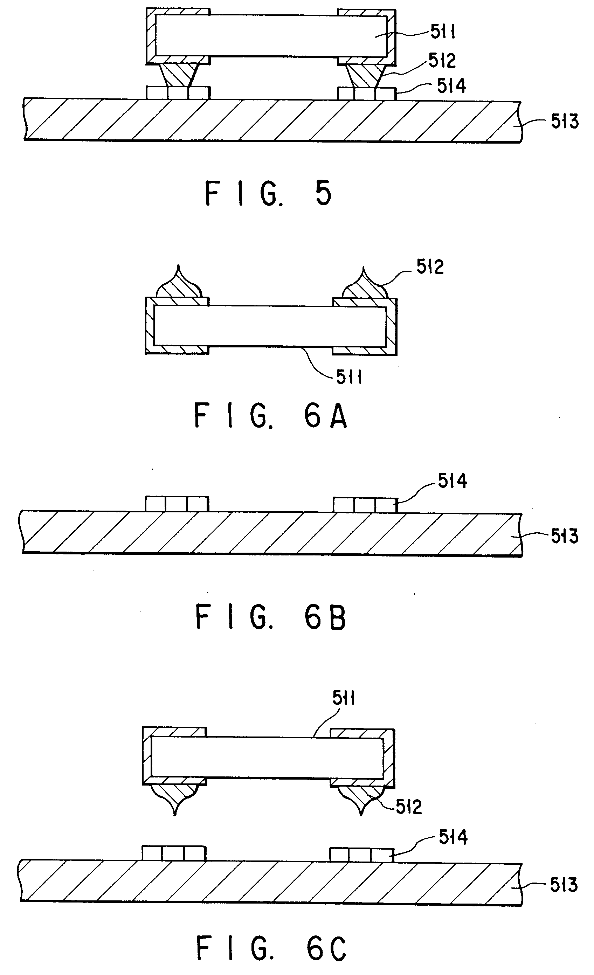

FIG. 5 is a sectional view showing part of an electronic circuit device as an example of the first embodiment of the present invention. In this electronic circuit device, a passive chip element is used as a micro electronic element. The electronic circuit device is mainly arranged such that an insulating substrate having a wiring pattern on a surface thereof is connected to a passive chip element through a bump, wherein solid-phase diffusion bonding is performed at least between the wiring pattern and the bump or between the bump and the passive chip element. The passive chip element is a constituent element such as a capacitor, resistor, and inductor.

As shown in FIG. 5, in this electronic circuit device, a passive chip element 511 is connected to each wiring layer 514 through a corresponding gold bump (projection electrode) 512. In this case, the gold bump 512 is formed as a bonding means on an electrode of the passive chip element by a ball-bonding method. The wiring layer 514 having the uppermost layer consisting of aluminum as a main component is formed on a substrate 513 consisting of a ceramic substrate. The gold bump 512 formed on the passive chip element 511 is bonded to aluminum of the wiring layer 514 by solid-phase diffusion bonding.

An example of the manufacturing process for realizing this electronic circuit device will be described below.

This manufacturing process includes the steps of: forming a wiring layer on an insulating substrate and arranging a passive chip element through a bump; and

heating the bump and the wiring layer to temperatures below melting points thereof so as to bond the wiring layer and the bump by solid-phase diffusion.

FIGS. 6A to 6C are views showing an example of the manufacturing process of the electronic circuit device shown in FIG. 5.

As shown in FIG. 6A, the electrode portions of a passive chip element 511 which consist of tin are subjected to gold ball bonding to form gold bumps 512. At this time, gold and tin are connected to each other in a eutectic state.

As shown in FIG. 6B, wiring layers 514 each having a two-layered structure consisting of a lower tungsten layer and an upper aluminum layer are formed in desired regions on a ceramic substrate 513.

A stage (not shown) which supports the substrate 513 is heated to 375°C, a passive chip element suction head (not shown) is heated to 300°C, and the gold bumps 512 are aligned with the wiring layers 514 so as to perform bonding, as shown in FIG. 6C. The gold bumps 512 are brought into tight contact with the corresponding wiring layers 514 with a load of 50 gf/bump for 0.15 sec, thereby connecting the passive chip element 511 to the substrate 513.

In the resultant electronic circuit device, the aluminum oxide film spontaneously formed on the surface of the aluminum layer of each wiring layer 514 is destroyed when each gold bump is brought into contact with and pressed on the corresponding aluminum layer to achieve solid-state diffusion bonding, thereby obtaining rigid bonding. A semiconductor element having gold bumps formed in the same method as described above can also be brought into tight contact with the aluminum layers. Therefore, semiconductor elements and passive chip elements which are mounted by different conventional methods can be connected in the same bonding process.

In the above electronic circuit device, each gold bump is formed on the corresponding electrode of the passive chip element. However, a gold bump may be formed on an aluminum wiring layer by ball bonding, and the tin electrode of the passive chip element may be connected to the gold bump. The gold bump may be formed by plating, deposition, or transfer in addition to ball bonding. In case that a semiconductor element is used as a micro electronic element, when corrosion of a semiconductor element electrode, which is a factor for degrading the reliability of the semiconductor element, is taken into consideration together with use of a bare chip, a transfer bump may cause corrosion from a boundary between the bump and the electrode of the semiconductor element. Although the ball-bonding method is easy and flexible, a larger number of bumps undesirably cause to prolong the manufacturing time. Therefore, the number of bumps is small, the ball-bonding method is advantageous. However, when the number of bumps is large, a deposition or plating method is desirable.

In the above electronic circuit device, each bump is made of gold, the uppermost wiring layer consists of aluminum, and gold and aluminum are bonded by solid-phase diffusion. However, the present invention is not limited to this combination. Any combination can be used if materials are subjected to solid-phase diffusion. In addition, homogeneous materials such as a gold bump and a gold wiring layer can be bonded to each other. Combinations of the materials are exemplified as follows.

| Combinations | |
| --- | --- |
| Bump | Wiring Layer |
| Au | Au |
| Au | Al |
| Au | Cu |
| Au | Sn |
| Cu | Cu, Au, Sn |
| Aℓ | Au, Su, Aℓ |

The present inventors compared the Au-Aℓ combination of the above combinations with a conventional solder (In-Sn).

Test 1

Table 1 summaries the resistance shear strength, the initial connection probability, the maximum resistance, the minimum resistance, the average resistance, the number of measured bumps, the standard deviation a, standard relative error $\sigma/\mu$, and the hysteresis after the Au bump is bonded to the Aℓ Wiring layer by solid-phase diffusion. As comparative examples, similar values obtained from bonding between InSn bumps and Au, Mo, and Aℓ Wiring layers are also listed in Table 1.

Table 1

| | Solid-Phase Diffusion Bonding | In/Sn Bump Compression Bonding | | |
|---|---|---|---|---|
| Bonded Surface | Au/Aℓ | InSn/Au | InSn/Mo | InSn/Aℓ |
| Resistance Shear Strength (Kgf) | 2.7 | 1.0 | 0.4 | 0.4 |
| Initial Connection Probability | | | | |
| Maximum Resistance ($\Omega$) | 0.065 | 1.55 | 9.09 | 12.1 |
| Minimum Resistance ($\Omega$) | 0.027 | 0.013 | 0.036 | 0.018 |
| Average Resistance ($\Omega$) | 0.033 | 0.043 | 0.78 | 1.01 |
| No. of Measured Bumps | 924 | 1045 | 2090 | 760 |
| Standard Deviation $\sigma$ ($\Omega$) | $5.42 \times 10^{-3}$ | 0.067 | 0.97 | 1.37 |
| Standard relative error $\sigma/\mu$ | 0.16 | 1.56 | 1.25 | 1.35 |
| Repairing Property | — | | | |

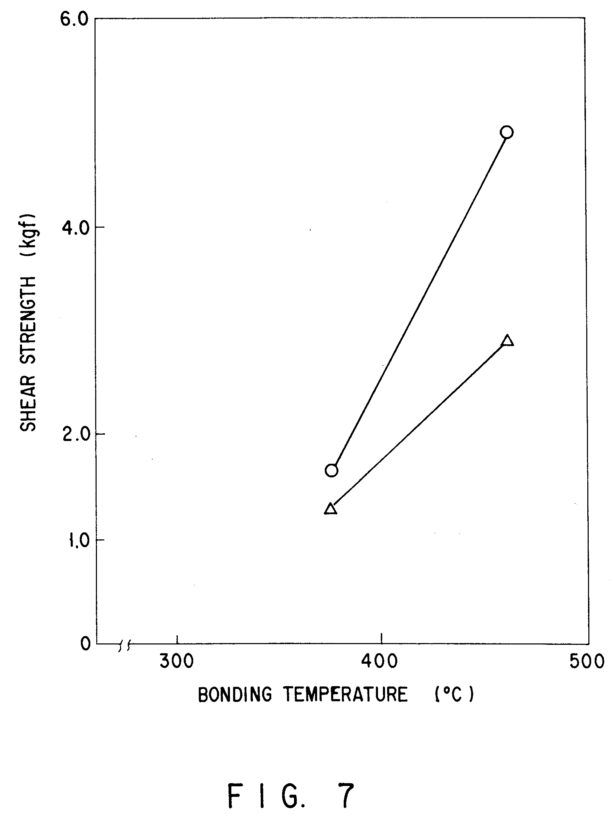

FIG. 7 shows the relationship between the shear strengths of a chip and a substrate as a function of chip temperature wherein 146 of bumps are in one chip, and the size of the bump is 75 × 55 $\mu$m and a bonding load as a parameter. The average shear strength is about 2.7 kgf/a chip (4.5 kgf/mm$^2$), the minimum shear strength is about 1.3 kgf/a chip (2.2 kgf/mm$^2$), and the maximum shear strength is about 4.9 kgf/a chip (8.1 kgf/mm$^2$). In the conventional In/Sn bump compression bonding, 400 gf and 380 gf are

8

obtained for Aℓ and Mo, respectively. Therefore, the shear strength of this embodiment is higher than that of the conventional bonding by several times.

Breaking upon shearing occurred between the InSn bumps and the wiring layers in all samples obtained in InSn bump compression bonding, and the reaction traces showing the solid-phase diffusion at the rupture cross-section was not confirmed. In solid-phase diffusion bonding between the Au bump and the wiring layer, breaking upon shearing occurred in a variety of regions, e.g., in chip Si, between Si and Aℓ pads, and between an Aℓ pad and a barrier metal, between a barrier metal and an Au bump, between an Aℓ bump and an Aℓ wiring layer, between an Aℓ wiring layer and a glass substrate, and in a glass substrate. It appears that bondings between Aℓ bump and Aℓ wiring strong and the other bonding among Si chip/Aℓ/brierr metal and Au/bump/Aℓ Wiring/Aℓ wiring, expectively, is similar to each other. In a breaking mode between the Aℓ bump and the Aℓ wiring layer, a reaction spot was confirmed on the Aℓ wiring layer. This reaction spot is as a solid-phase diffusion spot of Au/Aℓ as in Au/Aℓ wire bonding. According to the report by Iwata et al., the shear strength in this wire bonding is 8.9 kgf/mm$^2$. when a calculation is performed so as to correspond to this value, the shear strength of an IC chip (146 Au bumps each having a size of 55 × 75 $\mu$m) used by the present inventors becomes 5.4 kgf. This shear strength is lower than that in Au/Aℓ wire bonding. However, an Au ball in this wire bonding is subjected to plastic deformation by about 40%. For this reason, when a small deformation in the Au bump in the present invention due to a weak bonding load is taken into consideration, the shear strength (5.4 kgf) characteristics of the present invention are not inferior to those in ball bonding. When a cream solder is used, the shear strength is 3.5 kgf/mm$^2$ or more for a eutectic alloy, and the shear strength is 2.5 kgf/mm$^2$ for an 8%Bi-46%Sn-Pb solder. As compared with these values, the shearing strength characteristics of the Au/Aℓ bump are found to be excellent.

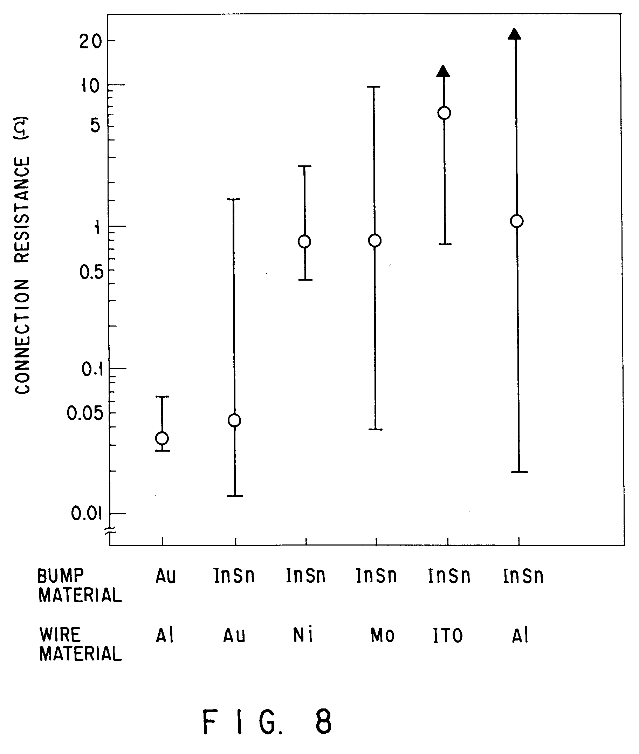

As shown in Table 1, the maximum connection resistance is as low as 65 mΩ in solid-phase diffusion bonding (Au/Aℓ). The relationship between the bump/wire material and the connection resistance is shown in FIG. 8. As can be apparent from this graph, the standard deviation is 5.4 mΩ, which indicates small variations in resistance. In this manner, solid-phase diffusion bonding apparently provides stabler connection than In/Sn bump compression bonding.

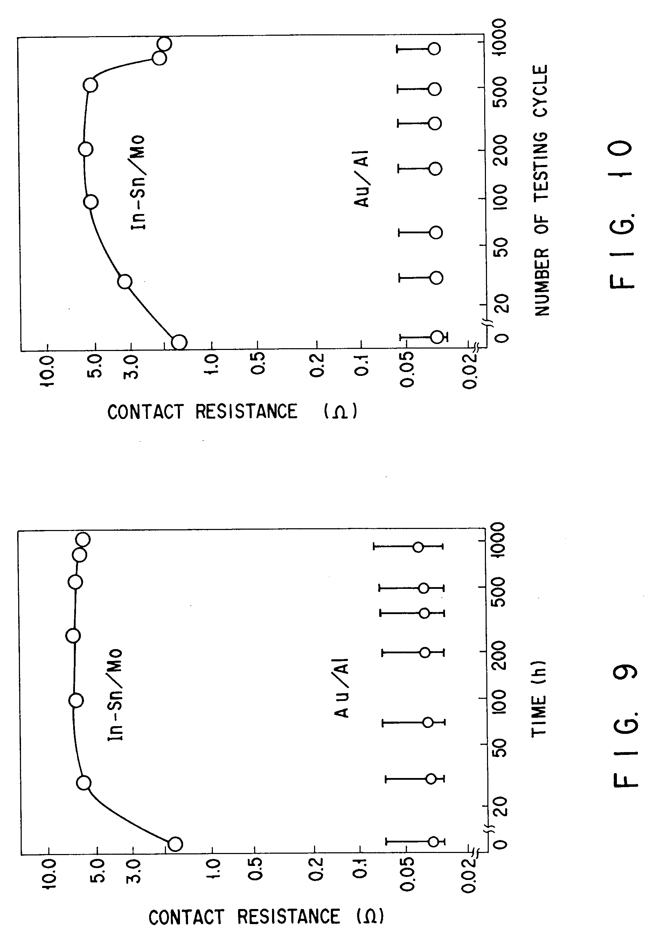

The present inventors conducted a high-temperature, high-humidity test at 70°C, 90% R.H., for 1,000 hours and a TST (Thermal Shock Test) at -40°C and 100°C for 30 minutes, respectively, 1000 cycles with regard to Au/Aℓ solid-state bonding and InSn/Mo compression bonding. FIG. 9 is a graph showing the results of the high-temperature, high-humidity test, while FIG. 10 is a graph showing the TST results. As can be apparent from these graphs, the resistance is high and greatly varies in compression bonding using the solder. However, in solid-phase diffusion bonding, the variations in resistance are reduced as compared with compression bonding, and a low resistance can be apparently maintained.

The solder is too soft, flexible, and deformable to perform bonding at a temperature below its melting point. For this reason, the solder is generally connected by an anchor effect. As described above, the solder has a low connection strength and variations in resistance, and cannot be connected to Aℓ because an oxide film on the surface of Aℓ cannot be destroyed. In addition, the solder itself has a low strength and poor reliability.

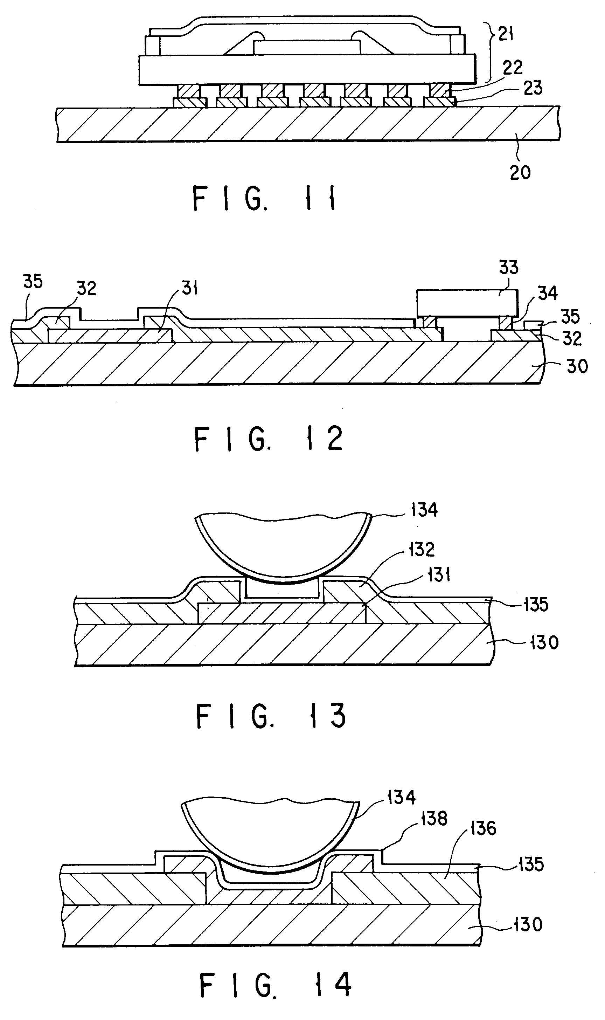

FIG. 11 is a view showing another example of the first embodiment of the present invention. This electronic circuit device uses a package incorporating a semiconductor element as a micro electronic element. The electronic circuit device is mainly arranged such that an insulating substrate having a wiring pattern on a surface thereof is connected to the package incorporating the semiconductor element through bumps, wherein solid-phase diffusion bonding is performed at least between the wiring pattern and the bump or between the bump and the electrode of the package.

As shown in FIG. 11, wiring layers 23 each constituted by a multilayered structure in which titanium, nickel, and gold are stacked in turn by sputtering in an order named on an alumina substrate 20 are used. Gold bumps 22 formed by plating or the like on the electrodes of the package 21 incorporating the semiconductor substrate are connected to the wiring layers 23. The gold bumps 22 of the package 21 are bonded to gold of the wiring layers 23 by solid-phase diffusion. An example of the manufacturing process for realizing this electronic circuit device will be described below.

Titanium, nickel, and gold are sputtered on the package 21 to form the electrode. Resist coating, patterning, electroplating, and the like are performed to form the gold bumps 22. A stage (not shown) which supports the substrate 20 is heated to 300°C, a head (not shown) which chucks the package is heated to 370°C, and compression bonding is performed with a load of 50 gf/bump for 0.15 sec to connect the package 21 to the substrate 20.

In the resultant electronic circuit device, the wiring layer 23 having the uppermost gold layer is bonded to the corresponding gold bump 22 by solid-phase diffusion, thereby obtaining rigid bonding.

FIG. 12 is a view showing still another example of the first embodiment of the present invention. In this electronic circuit device, an aluminum wiring is formed on an insulating substrate used in this device and can be used as a printing head. The electronic circuit device having this printing head comprises a substrate having resistance (heat generator) a wiring layer formed on the substrate and including a top layer containing aluminum as a main component, a bump bonded to the top layer by solid-phase diffusion bonding, and a semiconductor element mounted through the bump, wherein the thickness of the aluminum layer is 2,500Å to 15,500Å, and the thickness of the wiring layer is 3,000Å to 1,6000Å.

As shown in FIG. 12, in this electronic circuit device, an alumina substrate 30 is used as a ceramic substrate. A resistor 31 and wiring layers 32 are formed on this alumina substrate 30 by sputtering to constitute a printing head. Bumps 34 are formed on the wiring layers 32, and a drive semiconductor element 33 is connected through these bumps 34 by solid-phase diffusion. Reference numerals 35 denote protective layers.

More specifically, in this printing head, the gold bumps 34 formed on the electrodes of the semiconductor element 33 by electroplating or the like are connected to the aluminum wiring layers 32 formed on the alumina substrate 30. That is, the bumps 34 on the semiconductor element 33 are connected to the wiring layers 32 by solid-phase diffusion. Such printing head can be used as an element of a printer. In this embodiment, the thickness of each aluminum layer was 8,000Å and each gold bump had a size of 30 $\mu$m□. The bump pitch was 40 pm, and the number of bumps was 146. The semiconductor element was heated to 400$^0$C, the substrate was heated to 80°C, and compression bonding was performed with 25 gf/bump for 0.2 sec to cause a solid-phase diffusion reaction, thereby bonding the gold bumps to the wiring layers. The adhesion strength between the semiconductor element and the substrate upon bonding was 4.0 kgf, which was a sufficiently high strength. The contact resistance was 20 to 30 mΩ/bump. The resultant sample was subjected to a high-temperature, high-humidity test (70°C, 90%R.H, 1,000 hours), and a thermal shock test (-40°C/100°C, 30 min/30 min, 1,000 cycles). Variations in contact resistance fell within the range of ±10%, and it is thus found that stable electrical connection is achieved.

The adhesion strength between the semiconductor element 33 and the substrate 30 is evaluated under the above environmental conditions. The adhesion strength varied within about 10% with respect to the initial strength of 4.0 kgf, thus obtaining a satisfactory level in practical use.

A modification of the electronic circuit device having the above printing head will be described below. In this device, each wiring layer 32 was formed so that the aluminum layer had a thickness of 15,500Å, thereby obtaining an electronic circuit device in the same manner as in the electronic circuit device having the above printing head. This sample was tested following the same procedures as described above. The adhesion strength between the semiconductor element and the substrate upon bonding was 4.0 kgf, and a sufficiently high strength was maintained. The contact resistance was 20 to 30 mΩ/bump. A high-temperature test (70°C, 90%R.H., 1,000 hours) and a thermal shock test (-40°C/100°C, 30 min/30 min, 1,000 cycles) of this sample were conducted, and the variations in contact resistance fell within the range of ±10%, thus achieving stable electrical connection.

The adhesion strength between the semiconductor element 33 and the substrate 30 was evaluated under the same environmental conditions as described above in a shear test. Variations in adhesion strength fell within the range of about 10% with respect to the initial strength of 4.0 kgf, thereby obtaining a satisfactory level in practical use. No degradation in printing precision occurred.

Comparative Example 1

A sample was prepared as a comparative example of the electronic circuit device having a printing head, except that the thickness of an aluminum layer was 2,000Å. The same tests as described above were conducted for this sample. The adhesion strength between the semiconductor element and the substrate upon bonding was 0.9 kgf, which posed a problem in which the semiconductor element peeled off from the substrate soon. The intermetallic compound of aluminum and gold reaches below the aluminum wiring layer due to the decrease in adhesion strength.

Comparative Example 2

A sample was prepared as another comparative example except that the thickness of an aluminum layer was set to 20,000Å. The same tests as described above were conducted for this sample. The adhesion strength and contact resistance between the semiconductor element and the substrate upon bonding, and variations in contact resistance had satisfactory levels in practical use. However, printing precision was greatly degraded as compared with the aluminum film thickness of 15,500Å.

An electronic circuit device in which a printing head is bonded using bumps by solid-phase diffusion will be taken into consideration.

When the thickness of an aluminum layer as the uppermost layer of the multilayered wiring layer formed on a ceramic substrate is not more than 2,500Å, and the bump material consists of gold, an intermetallic compound of gold and aluminum, which compound serves as a solid-phase diffusion layer, reaches below the aluminum layer to greatly degrade the adhesion between the solid-phase diffusion layer and the underlying layer or substrate. Cracking, peeling, and the like tend to occur. On the other hand, when the thickness of the aluminum layer increases, the total thickness of the wiring layer increases to cause degradation in printing quality.

In consideration of the above problems, the present inventors optimized the thickness of the aluminum layer when a semiconductor element is mounted on a ceramic substrate constituting a printing head by utilizing metal solid-phase diffusion. The present inventors examined the relationship between growth of the intermetallic compound of aluminum and gold and the thickness of the aluminum layer.

As a result, when the thickness of the aluminum layer was smaller than 2,200Å in heating at 400°C for 0.2 sec, the solid-phase diffusion layer consisting of the intermetallic compound of aluminum and gold was found to be produced below the lower layer of the multilayered wiring layer, and cracking and peeling tended to occur. As a result of an experiment, the solid-phase diffusion layer of gold and aluminum is formed to a depth of about 2,200Å from the boundary between the gold bump and the aluminum layer. It was found that the thickness of the solid-phase diffusion layer varied in the range of 1,900Å to 2,500Å due to factors such as variations in heights of gold bumps and the inclination of a jig for bonding the semiconductor element. Therefore, the thickness of the aluminum layer is found to be at least 2,500Å so as to cause the aluminum layer not to grow and reach the layer underlying the aluminum layer. Examples of an intermetallic compound in solid-phase diffusion with regard to alminum and gold are $Au_5Al_2$, $Au_4Al$, $Au_2Al$, $AuAl$, and $AuAl_2$. In this embodiment, most of the compound observed is $Au4_Al$. In the reaction of alminum and gold. $Au_5Al_2$ and $Au_4Al$ can be formed stably. Practically, the thickness of this aluminum layer is preferably 15,500Å or less. If the thickness of the aluminum layer exceeds this value, it tends to cause blurring or the like, thereby degrading printing precision. The variations in thickness of the solid-phase diffusion layer falls within the range of 2,200 ±300Å. The thickness of the aluminum layer is required to at least 2,500Å or more. However, to improve the reliability of the device, the thickness of the aluminum layer is preferably not less than 2,600Å.

When the thickness of the aluminum layer is excessively large, the total thickness of the wiring layer tends to increase. FIGS. 13 and 14 show relationships between the wiring layers and the resistor portions of printing heads, respectively. As shown in FIG. 13, when a resistor 131 is formed on a substrate 130 and an aluminum wiring layer 132 is formed on the resistor 131, a distance between a printing medium 134 and the resistor 131 undesirably tends to increase to cause blurring or the like, thereby degrading printing precision. As shown in FIG. 14, when a resistor 138 is formed on an aluminum layer 136, the drawback shown in FIG. 13 and a drawback in which the resistor 138 is disconnected by the aluminum wiring layer 136 are caused. In particular, this typically occurs when the thickness exceeds 16,000Å. Reference numeral 135 denotes a protective layer. Therefore, the thickness of the entire wiring layer must be preferably 16,000Å or less. When a practical application is taken into consideration, the total thickness of the wiring layer is preferably 3,000Å or more. Otherwise, the printing head tends to have poor reliability.

In the electronic circuit device having the printing head according to the present invention, the thickness of the aluminum layer is set to 2,500Å or more, and the total thickness of the wiring layer is preferably set to 16,000Å or less. When a practical application is taken into consideration, the thickness of the aluminum layer is preferably set to 2,500Å to 15,500Å, and the total thickness of the Wiring layer is preferably set to 3,000Å to 16,000Å, thereby providing a printing head almost free from degradation in printing precision.

As described above, the technique according to the first embodiment of the present invention can be applied to a passive chip element, a package incorporating a semiconductor element, a printing head, and the like.

Since bonding can be performed by solid-phase diffusion without melting and connecting a solder, the spread of' the solder upon its melting and short-circuiting between adjacent electrodes can be almost prevented. Electronic circuit devices in which the passive chip element and the substrate, the package and the substrate, and the semiconductor element and the substrate are connected through the bumps at a high connection strength can be provided. When an oxide film is formed on a wiring pattern, heating and compression bonding are simultaneously performed to destroy the oxide film, thereby achieving connection having a high allowable current density.

According to the present invention, when a gold bump having a relative low hardness is used as a bump, a passivation film on a bonding pad of a semiconductor element will not crack. Since gold is rarely oxidized, solid-phase diffusion can be facilitated, and highly reliable bonding can be easily performed. In addition, when aluminum as a wiring metal subjected to solid-phase diffusion with gold is used, the connection resistance can be easily reduced to contribute to a reduction in production cost.

In actual mounting, when a semiconductor element is stamped on a heat source substrate, the bumps can have a predetermined height, and a plurality of bumps can be easily connected at once.

When bumps are selectively heated with an infrared ray or the like, only bump portions are heated to a temperature required for bonding, and the bumps can be connected to the substrate before the bump temperature is reduced. In this case, heat conduction is delayed to prevent a semiconductor element failure caused by an increase in temperature. That is, when infrared heating is used, the bump portion can be efficiently heated, while the semiconductor element need not be heated, thereby preventing thermal degradation of the semiconductor element.

When a metal layer having a low heat conductivity is formed as a barrier layer between a semiconductor element and a bump, heat conduction to the semiconductor element can be prevented, and an increase in temperature of the semiconductor element can be prevented.

In addition, when a bump is formed to have a concave recess, an area of the boundary between the solid-phase diffusion layer and the wiring layer can be increased to increase the bonding strength, thereby achieving highly reliable connection.

The second embodiment of the present invention will be described below.

The second embodiment provides a semiconductor device as a more practical example of the first embodiment.

The second embodiment of the present invention is an example of the first embodiment and provides a semiconductor device comprising:

an insulating substrate;

a wiring layer formed on the insulating substrate;

bump-like bonding means bonded to a surface of the wiring layer by solid-phase diffusion; and

a semiconductor element formed on the bonding means.

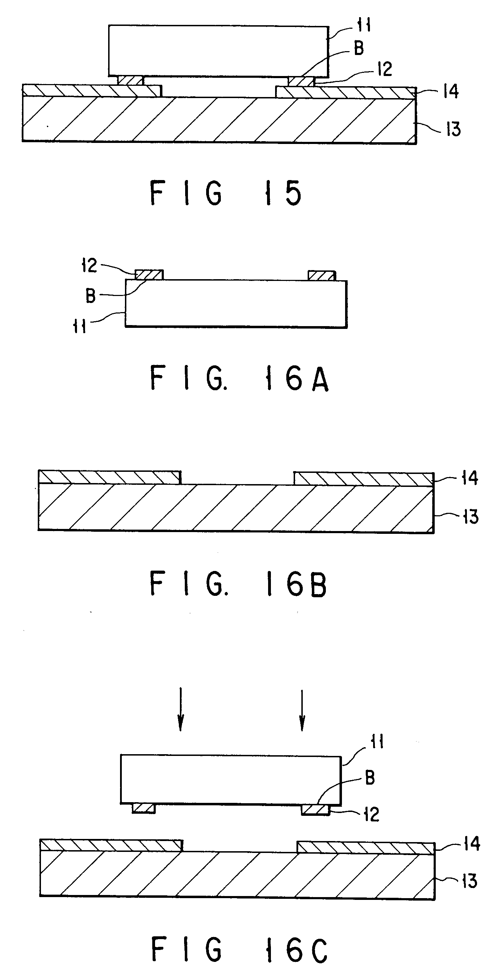

FIG. 15 is a view showing a semiconductor device according to the second embodiment of the present invention. This semiconductor device is used for a liquid crystal panel. The semiconductor device comprises a semiconductor element 11, gold bumps 12 formed on the surface of the semiconductor element 11 by electroplating or the like, molybdenum/aluminum multilayered wiring layers 14 bonded to the corresponding gold bumps 12 by solid-phase diffusion, and the multi-layered wiring layers 14 are formed on a wiring substrate 13. The wiring substrate 14 consists of a glass substrate, and each gold bump 12 of the semiconductor element 11 is connected to aluminum of the corresponding wiring layer 14 by solid-phase diffusion. In the semiconductor device shown in FIG. 15, the gold bumps 12 are connected to the aluminum layers of the corresponding wiring layers 14 by solid-phase diffusion.

The wiring substrate has thin film transistors, a liquid crystal, polarizing plates, and the like, all of which are formed on the glass substrate.

An example of the manufacturing process of the semiconductor device shown in FIG. 15 will be described below.

FIGS. 16A to 16C are views for explaining this manufacturing process. This manufacturing process includes the step of connecting, through a bump, a semiconductor element to the Wiring pattern formed on the surface of the insulating substrate, wherein the bump and the wiring pattern are heated to temperatures lower than their melting points so as to bond the wiring pattern to the bump by solid-phase diffusion. As shown in FIG. 16A, as a barrier metal B, a titanium layer, a nickel layer, and a palladium layer are formed on the bonding pad of the semiconductor element from the semiconductor element side, and the resultant structure is electroplated to obtain the gold bumps 12. In this case, the titanium layer is formed to increase the adhesion strength with the aluminum pad, the nickel layer is formed to prevent diffusion of gold into the bonding pad of the semiconductor element, and the palladium layer is formed to increase the bonding strength with gold.

As shown in FIG. 16B, wiring patterns each constituted by a two-layered structure consisting of a lower molybdenum layer and an upper aluminum layer are formed in desired regions on the glass substrate. In this case, 26 input pads and 120 output pads are formed on each glass substrate.

The semiconductor element side is heated to 400°C, the glass substrate side is heated to 80°C, the semiconductor element and the substrate are positioned, as shown in FIG. 16C, and compression bonding is performed with a load of 30 g/bump for 0.2 sec, thereby connecting all the pads at once. The adhesion strength between the semiconductor element and the glass substrate upon bonding was about 4.0 kgf.

In the resultant semiconductor device, each gold bump is brought into tight contact with the corresponding aluminum layer to destroy the oxide film formed on the aluminum layer of the wiring layer 14. In this case, solid-phase diffusion bonding is performed to obtain rigid bonding to increase the allowable current value and reduce the connection resistance.

Since all the connections can be obtained at once, the bonding time can be greatly reduced as compared with one-to-one wire bonding which takes 17.5 sec (0.12 sec for each bonding wire). In addition, the required mounting area for bump connection can be greatly reduced.

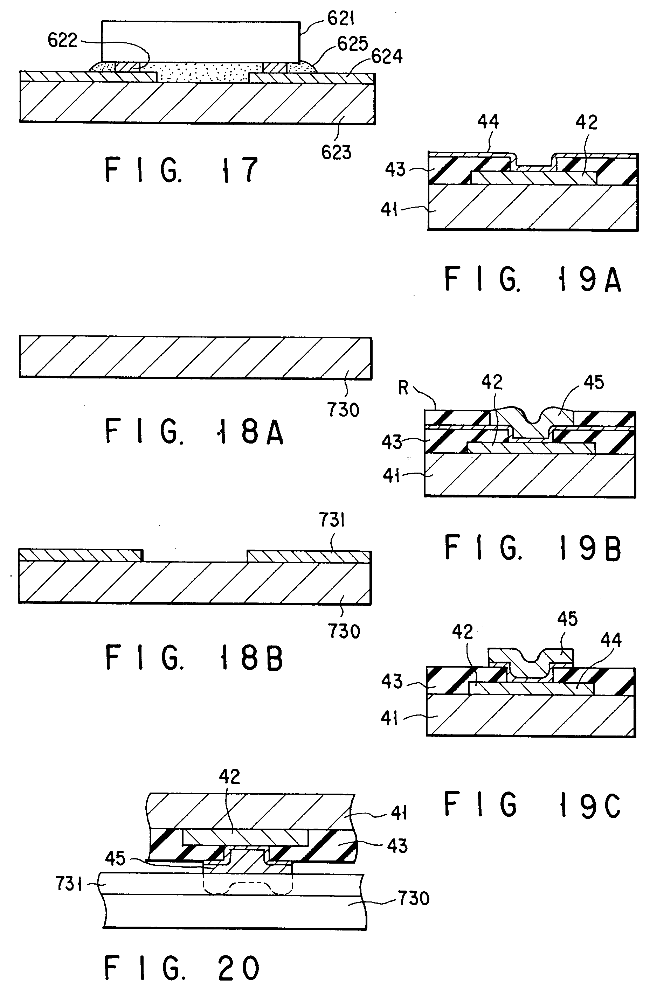

FIG. 17 is a view showing another example of the semiconductor device according to the second embodiment of the present invention. More specifically, FIG. 17 is a sectional view of the semiconductor device according to the second embodiment of the present invention.

In this example, an alumina substrate 623 is used as a substrate, and resistor patterns (not shown) and wiring patterns 624 such as electrode wiring layers are formed on the alumina substrate by sputtering, and a drive IC chip 621 is connected to the wiring patterns 624 by solid-phase diffusion. The drive IC chip 621 is adhered to the alumina substrate 623 with an insulating adhesive 625 to seal, thereby preventing the bump connection from ambient condition such as penetrating of moisture.

That is, in this semiconductor device, the semiconductor element or IC chip 621 is connected to the aluminum wiring layers 624 formed on the alumina wiring substrate 623 through gold bumps 622 formed on the semiconductor element 621 by electroplating or the like. The gold bumps 622 of the semiconductor element 621 are connected to the wiring layers 624 by solid-phase diffusion. That is, the gold bumps 622 are connected to the aluminum wiring layers 624 by solid-phase diffusion.

A manufacturing process of this semiconductor device will be described below.

As barrier metals B, a titanium layer, a nickel layer, and a palladium layer are formed on the bonding pads of the semiconductor element, and the gold bumps 622 are formed on the bonding pads through these layers. The gold bumps 622 have variations of ±1.5 $\mu$m in height. The gold bumps 622 are stamped on a heat source substrate to set the height of the bumps constant.

After the resistor patterns are formed on the alumina substrate 623 by sputtering, wiring patterns 624 each constituted by a two-layered structure of W and Aℓ are formed as electrode patterns from the substrate side. All the pads are brought into tight contact with the electrode patterns at once, and the alumina substrate 623 are heated to bond the bumps to the electrode patterns by solid-phase diffusion. The resultant semiconductor device has the effect of the above semiconductor device and an effect of preventing heat conduction from the alumina substrate 623 to the semiconductor element 621 because titanium has a lower heat conductivity than that of gold. As a result, an increase in temperature of the semiconductor element 621 can be prevented.

The semiconductor element 621 is compressed by the above stamping to align the heights of the bumps, thereby achieving accurate, more reliable connection. In addition, when the gold bumps 622 are selectively heated with an infrared ray or the like in place of heating the alumina substrate 623, only the gold bumps 622 can be heated to suppress the influence of heat to the semiconductor element 621.

Still another example of the second embodiment according to the present invention will be described below.

FIGS. 18A and 18B are views for explaining a manufacturing process of a wiring substrate used in this example of the second embodiment of the present invention. The wiring substrate is formed as follows. An aluminum thin film is formed on a ceramic substrate 730 shown in FIG. 18A by sputtering. The aluminum thin film is patterned by photolithography to obtain wiring patterns 731 consisting of aluminum shown in FIG. 18B.

FIGS. 19A to 19C are views for explaining a process of forming bumps. As shown in FIG. 19A, a silicon substrate having a desired element formation area is prepared as a semiconductor element 41, and a silicon nitride film 43 serving as a passivation film is formed on an aluminum wiring pattern 42 formed on the surface of this silicon substrate. A contact hole is formed in the silicon nitride film by photolithography. A barrier metal layer 44 consisting of titanium, nickel, and palladium is formed by vacuum deposition.

As shown in FIG. 19B, a resist R is applied to the barrier metal layer 44 and patterned. The resultant structure is dipped in a plating solution to electroplate the barrier metal layer 44 as an electrode, thereby selectively forming a gold bump 45 on the barrier metal layer 44 exposed from the resist R.

Finally, as shown in FIG. 19C, the resist R is removed, and the barrier metal layer 44 is partially etched using the bump 45 as a mask to obtain the bump 45 whose central portion is recessed in a concave shape.

In actual mounting, the resultant semiconductor element 41 is located above the wiring pattern 731 on the ceramic substrate 730 shown in FIG. 18B and is heated to about 400°C to bond the bump 45 to the wiring pattern 31.

FIG. 20 shows a view showing a state in which the bump according to the second embodiment of the present invention is bonded to the wiring pattern. At this time, since the central portion of the bump 45 has the recess in the concave shape, a solid-phase diffusion layer is formed, as indicated by a dotted line in

EP 0 615 284 A2

FIG. 20. The area of the boundary between the solid-phase diffusion layer and the aluminum wiring layer 731 is increased to obtain a high bonding strength.

In the resultant semiconductor device, even if an oxide film is formed on the aluminum wiring layer 731 on the ceramic substrate 730, the oxide film can be properly destroyed by compression bonding, and good bonding can be assured by solid-phase diffusion. Therefore, the allowable current value can increase and the connection resistance can be reduced.

According to the present invention, even if a wiring layer such as an aluminum wiring layer has a rigid oxide film and a wiring substrate consists of a material having poor wettability with the solder, the semiconductor element or the like can be properly bonded to the semiconductor substrate by solid-phase diffusion bonding. At the same time, highly reliable connection with a high mechanical strength can be achieved.

As described above, the semiconductor device according to the present invention uses a glass substrate for a flat display such as a liquid crystal display device or a ceramic substrate for a printing head.

The third embodiment of the present invention will be described below.

According to the third embodiment of the present invention, there is provided a liquid crystal display device comprising a pair of substrates, a liquid crystal sandwiched between the pair of substrates, a wiring layer formed on one of the pair of substrates and including a top layer containing aluminum as a main component, and a semiconductor element formed on the wiring layer through a bump wherein the bump and the aluminum layer are bonded to each other by solid-phase diffusion, the aluminum layer has a thickness of 2,500Å to 8,000Å or more, and the wiring layer has a thickness of 3,000Å to 8,500Å or less.

In this liquid crystal display device, the wiring pattern has a layer containing at least aluminum as a main component, as an uppermost or top layer. Layers of other materials such as molybdenum, chromium, and a molybdenum-tungsten alloy may be formed as underlying layers of the aluminum layer, thereby obtaining a multilayered wiring pattern. In this case, the thickness of the Wiring layer means the thickness of the multilayered wiring layer.

The following points are preferably taken into consideration when the technique of the present invention is applied to a liquid crystal display device.

When the thickness of the aluminum layer as the uppermost layer of the wiring pattern formed on the glass substrate, an intermetallic compound serving as a solid-phase diffusion layer of a bump consisting of aluminum and gold is produced in a layer (e.g., an Mo layer) underlying the aluminum layer to greatly decrease the bonding strength between the solid-phase diffusion layer and the underlying molybdenum layer, thereby maybe causing cracking and peeling.

When the thickness of the aluminum layer increases, the total thickness of the wiring pattern increases. In rubbing (aligning) a liquid crystal portion, uniform alignment cannot be performed due to the large thickness of the wiring pattern. As a result, the display screen tends to become irregular.

In consideration of the above problem, the present inventors optimized the thickness of an aluminum wiring layer when a semiconductor element was mounted on an LCD substrate utilizing metal solid-phase diffusion on the basis of the technique of the present invention. The present inventors examined the relationship between the growth of the intermetallic compound of aluminum and gold and the thickness of the aluminum wiring layer. As a result, when the thickness of the aluminum layer is smaller than 2,200Å in heating at 400°C for 0.2 sec, the solid-phase diffusion layer consisting of the intermetallic compound of aluminum and gold is produced in the lowermost layer of the wiring layer, and cracking and peeling tend to occur. As a result of an experiment, the solid-phase diffusion layer of aluminum and gold was diffused to a depth corresponding to the thickness of 2,200Å from the boundary between the gold bump and the aluminum layer. It was found that the thickness of the solid-phase diffusion layer varied in the range of 1,900Å to 2,500Å due to factors such as variations in heights of gold bumps and the inclination of the semiconductor element. Therefore, the thickness of the aluminum layer was found to be at least 2,500Å so as to cause diffusion of the solid-phase diffusion layer not to reach the underlying layers consisting of molybdenum, chromium, and a molybdnum-tungsten alloy. The variations in thickness of the solid-phase diffusion layer falls within the range of 2,200 ±300Å. The thickness of the aluminum layer is required to at least 2,500Å or more. However, to improve the reliability of the device, the thickness of the aluminum layer is preferably 2,600Å or more. In practice, when the thickness of this aluminum layer is preferably 8,000Å or less. If the thickness exceeds this value, it tends to occur reverse of liquid crystal alignment because uniform rubbing treatment cannot be performed.

When the thickness of the aluminum layer is excessively large, the total thickness of the wiring pattern tends to increase. Irregularities tend to occur in rubbing (aligning) the liquid crystal portion.

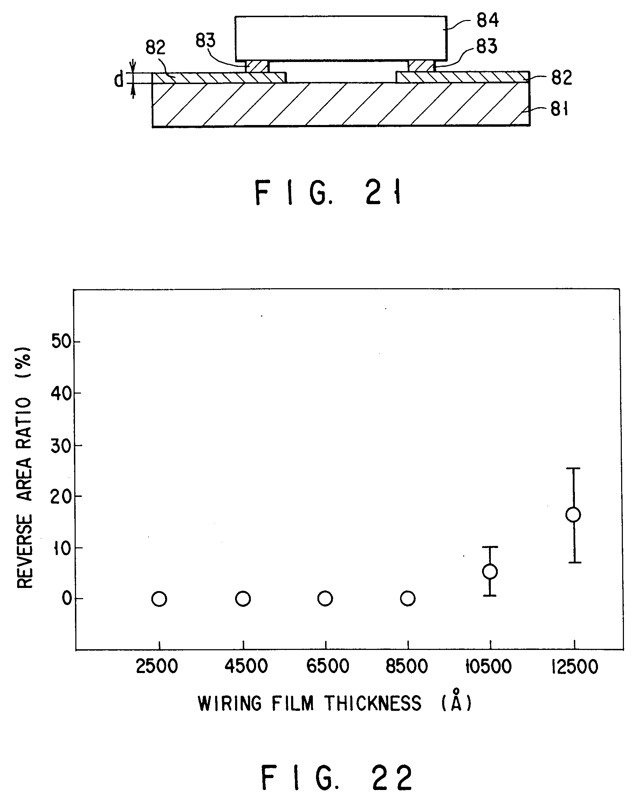

An irregularity ratio is represented by a reverse area ratio (i.e., [area subjected to reverse discrimination on

14

one screen] / [area of one screen]), and the relationship between this and the wiring thickness is shown in FIG. 22. As can be apparent from FIG. 22, when the wiring thickness is 8,500Å or less, no irregularities occurred in rubbing the liquid crystal portion. However, when the wiring thickness exceeds 8,500Å, the reverse area is found to increase. When a practical application is taken into consideration, the total wiring thickness is preferably 3,000Å or more. Otherwise, reliability tends to decrease due to growth of a diffusion layer.

In consideration of the above findings, there can be provided a highly reliable liquid crystal display device free from rubbing irregularities when the thickness of the aluminum layer is set to 2,500Å or more and the total wiring thickness is set to 8,500Å or less.

FIG. 21 is a schematic view showing an example of the liquid crystal display device according to the third embodiment of the present invention.

As shown in FIG. 21, a semiconductor element 84 is connected through gold bumps 83 to molybdenum/aluminum wiring layers 82 formed on a glass substrate 81. In this case, gold of each gold bump 83 is directly bonded to aluminum of the corresponding molybdenum/aluminum wiring layer 82 by solid-phase diffusion. In this liquid crystal display device, the thickness of the aluminum layer was 5,000Å, and the thickness of the molybdenum layer was 500Å. The gold bumps 83 were formed by electro plating. The size of each bump was 50 $\mu$m, the bump pitch was 80 $\mu$m, and the bump height was 20 $\mu$m.

An TFT-LCD substrate was used as the glass substrate 81. Although not shown, a portion elongated below the glass substrate 81 constitutes a TFT-LCD. Wiring patterns 82 each constituted by a structure obtained by stacking molybdenum and aluminum from the upper surface side are formed on the substrate 81. The molybdenum/aluminum wiring layers 82 are formed on the substrate 81 by sputtering. That is, a 5,000-A thick aluminum layer is formed on a 500-Å thick molybdenum layer. The gold bumps 83 and aluminum are subjected to solid-phase diffusion at 300 to 500°C to form a gold-aluminum alloy.

In this liquid crystal display device, the semiconductor element 84 having 26 input bumps and 120 output bumps was used, the semiconductor element 84 was heated to 400°C, the glass substrate 81 was heated to 80°C, and compression bonding was performed with a load of 30 g/bump to cause a solid-phase diffusion reaction between gold and aluminum, thereby bonding the gold bumps 83 to the wiring layers 82.

After bonding, the adhesion strength between the semiconductor element 84 and the glass substrate 81 was 4.0 kgf, thus maintaining a sufficient high strength. The contact resistance was 20 to 30 mΩ/bump. A high-temperature, high-humidity test (70°C, 90%R.H., 1,000 hours) and a thermal shock test (-40°C/100°C, 30 min/30 min, 1,000 cycles) of the resultant sample were conducted. Variations in contact resistance fell within the range of ±10%, thus achieving extremely stable electrical connection.

The adhesion strength between the semiconductor element 84 and the glass substrate 81 was evaluated by a die share under the same environmental conditions as described above. The variations in adhesion strength fell within the range of about 10% with respect to the initial strength of 4.0 kgf, thus obtaining a satisfactory level in practical use. No defects were found in rubbing the liquid crystal portion.

Another example of the liquid crystal display device according to the third embodiment of the present invention will be described below.

In this example, a sample as in the liquid crystal display device shown in FIG. 21 was obtained except that the total thickness of each wiring pattern 82 was 8,500Å in such a manner that the thickness of an aluminum layer of each wiring layer 82 was 8,000Å and the thickness of a molybdenum layer was 500Å.

The same tests as described above were conducted for this sample. The adhesion strength between a semiconductor element 84 and a glass substrate 81 upon bonding was 4.0 kgf, thus maintaining a sufficiently high strength. The contact resistance was 20 to 30 mΩ per a bump. The same reliability test as described above was conducted for this sample, and variations in contact resistance fell within the range of ±7%, thus achieving extremely stable electrical connection. When the adhesion strength between the semiconductor element and the glass substrate was evaluated by a die share under the same environmental conditions described above, the variations in adhesion strength fell within the range of about 10% with respect to the initial strength of 4.0 kgf, thus obtaining a satisfactory level in practical use. As can be apparent from FIG. 22, no defects occurred in rubbing a liquid crystal portion.

A comparison test was performed for one example and still another example of the liquid crystal display device shown in FIG. 21.

Comparative Example 3

A sample as in the fourth embodiment except that the thickness of an aluminum layer was 2,000Å was prepared. The same tests as in the liquid crystal display device shown in FIG. 21 were conducted for this sample. The adhesion strength between a semiconductor element and a glass substrate was 0.9 kgf, and the semiconductor element peeled off from the glass substrate soon. This is because an intermetallic compound of aluminum and gold reached the molybdenum interface below the aluminum wiring layer.

Comparative Example 4

A sample was prepared as in the liquid crystal display device shown in FIG. 21 except that each Wiring layer 83 having a thickness of 10,500Å was formed such that the thickness of an aluminum layer was 10,000Å and the thickness of a molybdenum layer was 500Å. The same tests as described above were conducted for this sample. The adhesion strength and contact resistance between a semiconductor element 84 and a glass substrate 81 and variations in contact resistance have satisfactory levels in practical use. However, as shown in FIG. 22, it was found that the liquid crystal display device was degraded because the defects were formed by a maximum of 10% in rubbing a liquid crystal portion.

A temperature at which a bump reacts with a wiring layer is preferably low to prevent damage to the semiconductor device. In particular, when a liquid crystal device using a liquid crystal having a low heat-resistant temperature and polarizing plates having a low heat-resistant temperature is assumed in COG (Chip On Glass) mounting, a liquid crystal panel having thin film transistors, a liquid crystal, and polarizing plates is often used as the glass substrate. For this reason, the liquid crystal panel has temperature limitations. Although the liquid crystal panel can be locally heated to several hundreds of °C, a temperature applied to a pixel portion is preferably 100°C or less and apart from a semiconductor element more than 2 mn in consideration for simulation and the result of thetest. ITO is generally used as a wire material of the liquid crystal panel. The wiring resistance is preferably low. For this reason, ITO is used in combination with a metal wiring material. Of these combinations, use of aluminum having a low resistance and-high stability as a COG mounting wiring material is advantageous in view of performance, reliability, and cost. The present invention is also effective in mounting such as COB (Chip On Board) mounting in addition to COG mounting.

In the liquid crystal display device according to the third embodiment of the present invention, the bumps are connected to the wiring patterns formed on the mounting insulating substrate by solid-phase diffusion. For this reason, an extremely high connection strength can be obtained. In addition, even if an oxide film is formed on a wiring pattern, compression bonding is performed together with heating, thereby destroying the oxide film and hence achieving connection having a high allowable current density.

As described above, according to the present invention, there is provided a semiconductor device having micro pitch connections wherein connection with a wiring substrate having a Wiring pattern consisting of a material having poor wettability with the solder due to the presence of a rigid oxide film such as an aluminum oxide film on an aluminum wiring layer can be properly and highly reliably performed by solid-phase diffusion bonding. There is also provided a high-quality liquid crystal display device wherein the thickness of a wiring pattern applied to a liquid crystal display device is set to 2,500Å or more and 8,500Å or less to obtain a sufficiently high adhesion strength and a sufficiently low contact resistance.

The fourth embodiment of the present invention will be described below.

According to the fourth embodiment of the present invention, there is also provided a circuit substrate comprising a substrate, and a multilayered Wiring layer constituted by a first metal layer formed on the substrate, an oxide film formed on the first metal layer and consisting of the same metal as that of the first metal layer, and a second metal layer formed on the metal oxide film and consisting of a metal as in the first metal layer.

This multilayered wiring layer can be used in a variety of applications as the wiring layers used in the first to third embodiments.

The fourth embodiment of the present invention will be described with reference to the accompanying drawings. This embodiment will exemplify flip-chip mounting using solid-phase diffusion bonding.

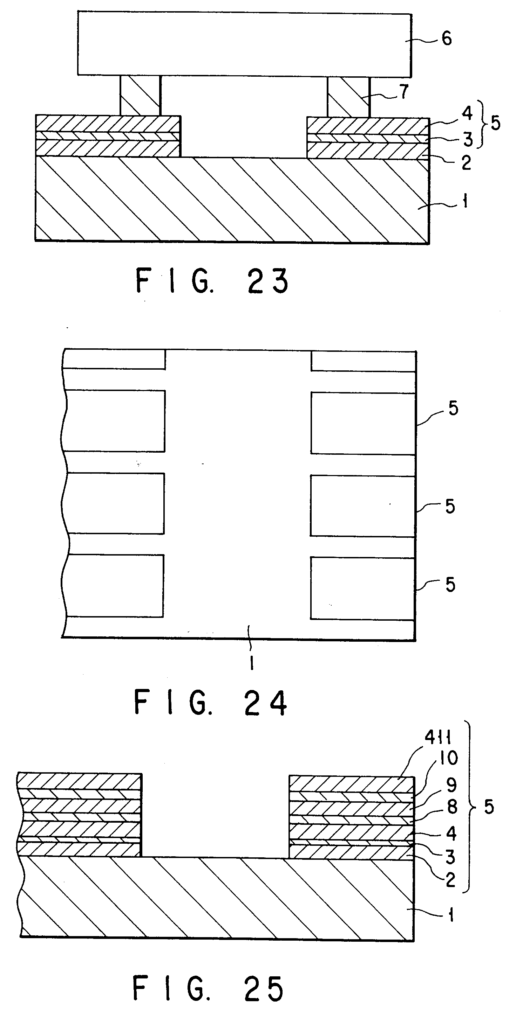

FIG. 23 is a view showing a state in which a semiconductor element is mounted on a circuit board according to an example of the fourth embodiment of the present invention. Referring to FIG. 23, an insulating substrate 1 comprises a glass substrate, a ceramic substrate, or a metal core substrate. FIG. 24 is a plan view of FIG. 23. Each multilayered pattern or layer 5 obtained by sequentially stacking a first metal layer 2, an oxide layer 3, and a second metal layer 4 is selectively formed, as shown in FIG. 24. Each bump 7 of the semiconductor element 6 is bonded to the corresponding multilayered pattern 5 by solid-phase diffusion. For this reason, the materials of the first and second metal layers (wiring layers) and the bumps 7 are determined under the conditions that the bumps are reacted with the wiring layers by solid-phase diffusion to obtain mechanical and electrical connections, and that the first and second metal layers produce an oxide. More specifically, each bump 7 is made of copper, gold, aluminum, tin, or an alloy containing such a metal material. The wiring layers, i.e., the first and second metal layers 2 and 4 are made of a metal (e.g., aluminum, copper, or tin) or an alloy containing such a metal. The bump and the metal layers are subjected to solid-phase diffusion at temperatures lower than their melting points to bond the bumps to the metal layers.

In this circuit substrate, the bumps 7 are made of gold, and the metal layers 2 and 4 serving as the wiring layers are made of aluminum. In this case, when each gold bump 7 is brought into tight contact with the corresponding aluminum wiring layer, i.e., the corresponding multilayered pattern 5, an oxide film (not shown) on the second metal layer 4 is destroyed, so that gold of the bump directly reacts with aluminum of the multilayered film.

To form the bumps 7, a method such as deposition, plating, or transfer is used. The bumps are formed in this circuit substrate by plating. A lot of known examples are proposed as methods of forming bumps by plating, and a detailed description thereof will be omitted. The wiring multilayered pattern 5 is formed as follows. More specifically, molybdenum is formed by sputtering to a thickness of 500Å on a non-alkali glass having a thickness of 1.1 mm and a diameter of 5 inches. The aluminum layer 2 is then formed on the molybdenum layer to a thickness of 3,000Å. At this time, the conditions are given such that the vacuum degree is $6 \times 10E-4Pa$, the substrate temperature is 150°C, and the argon pressure is $7 \times 10E-1Pa$. After the aluminum layer 2 is formed, the vacuum state of the process chamber is returned to the atmospheric state. Alumina 3 as an aluminum oxide is formed on the aluminum layer 2 to a thickness of 5 to 100Å, and preferably about 45Å. Thereafter, the process chamber is then set in a vacuum state again, and the aluminum layer 4 is formed on the alumina 3 to a thickness of 3,000Å. After this film formation, the resultant structure is patterned to form wiring patterns. Patterning is performed by general methods such as resist coating, exposure, and etching.

Bonding of the semiconductor element 6 on the above wiring patterns 5 on the circuit substrate will be described below.

The semiconductor element 6 having input and output bumps is heated to 380°C, and the glass substrate 3 is heated to 80°C. In this state, the bumps of the semiconductor element are brought into tight contact with the circuit substrate with a load of 20 g for 0.8 sec to bond the gold bumps 7 to the wiring patterns 5 by solid-state diffusion. At this time, the gold bumps are bonded to the second metal layers 4 of the wiring patterns 5, respectively. A strength required to forcibly peeling the semiconductor element 6 from the circuit substrate upon bonding is 1.8 kg, thus obtaining a sufficiently high strength in practical use. In this peeling operation, the second metal layer 4 is peeled from the insulating film 3 or the insulating film 3 is peeled from the first metal layer 2. After pealing, the circuit substrate is cleaned, another semiconductor element is bonded to this circuit substrate under the same conditions as described above, thereby bonding gold bumps to the aluminum wiring pattern 5 by solid-phase diffusion. At this time, since the second metal layer 4 is not present in a peeled portion, so that the metal bumps 7 of the new semiconductor element are bonded to the first metal layers 2 by solid-phase diffusion bonding, respectively. After this re-bonding, the operation of the semiconductor element was examined, and it was confirmed that the semiconductor element was normally operated.

In the above example, the wiring pattern 5 has a three-layered structure consisting of the first metal layer 2, the oxide layer 3, and the second metal layer 4. The number of layers constituting the wiring pattern may be four or more. For example, another example of the fourth embodiment of the present invention is shown in FIG. 25. As shown in FIG. 25, each multilayered pattern or layer 5 is formed by alternately forming metal layers 2, 4, 9, and 11, and oxide layers 3, 8, and 10. Since the wiring pattern 5 has a multilayered structure, peeling can be performed between different layers. This circuit substrate can be repaired a plurality of times. In particular, in this circuit substrate, the oxide layers 3, 8, and 10 are formed such that their thicknesses are gradually increased within the range of, e.g., 5 to 100Å. That is, the lowermost oxide layer 3 has the smallest thickness, and the intermediate oxide layer 8 and the uppermost oxide layer 10 sequentially have larger thicknesses. In peeling, the layers are peeled from the uppermost layer, so that the circuit substrate can be repaired at least twice. The thicknesses of the oxide layers can be sequentially increased by, e.g., gradually increasing the oxidation times in a non-vacuum atmosphere.

In peeling the semiconductor element bonded to the first metal layer, the oxide layer, and the second metal layer on the circuit substrate in accordance with solid-phase diffusion, the semiconductor element is peeled from the substrate at the boundary between the oxide layer and one of the first and second metal layers because this boundary has the lowest adhesion strength. After peeling, bumps on another semiconductor element can be bonded to the metal layers by solid-phase diffusion.

According to the present invention, therefore, a repairing operation for assuring highly reliable connection can be easily realized.

The fifth embodiment of the present invention will be described below.

According to the fifth embodiment of the present invention, there is provided a circuit substrate comprising a substrate, a wiring layer formed on the substrate, and first and second pad arrays formed on the wiring layer,

wherein the first and second pad arrays are defined such that a central coordinate position of the second pad array is defined as $(xi+j,yi+k)$ ($i$ = 1 to n; $j$ and $k$ are moving distances) when a central coordinate position of the first pad array is defined as $(xi,yi)$ ($i$ = 1 to n).

This wiring pattern can be used in a variety of applications as the wiring layers of the first to third embodiments.

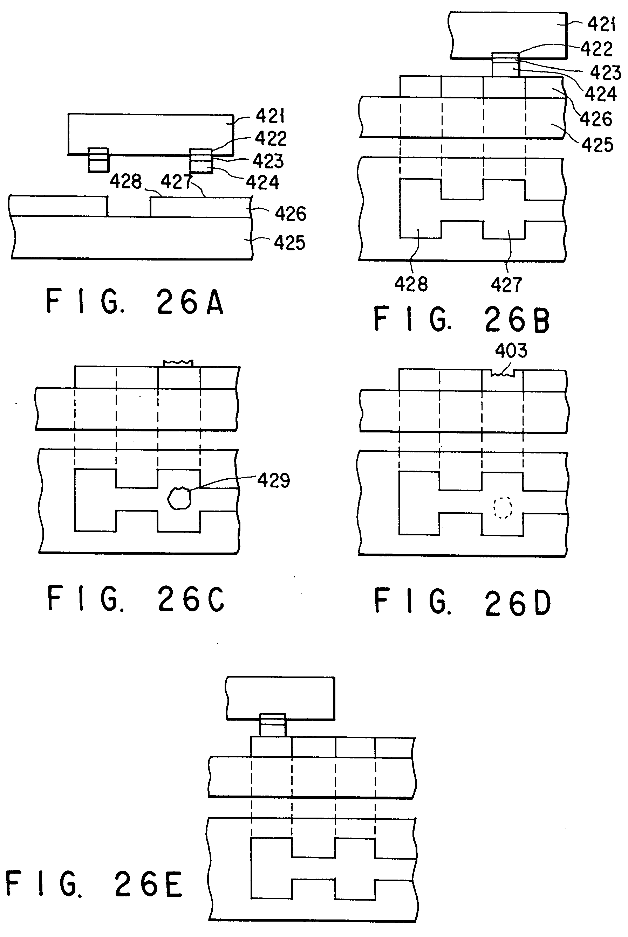

FIGS. 26A to 26E are schematic views showing an example of the fifth embodiment of the present invention.

FIGS. 26A to 26E show the principle of this embodiment, i.e., the repairing process of a semiconductor device. More specifically, as shown in FIG. 26A, bonding pads 422 are formed on a semiconductor element 421, and barrier layers 423 formed of titanium, nickel, and palladium are stacked on the bonding pads 422, respectively. Gold bumps 424 are formed on the barrier layers 423, respectively. The semiconductor element 421 is mounted on a circuit substrate. This circuit substrate comprises an insulating substrate 425, wiring patterns 426 made of aluminum, copper, or the like, a first bonding pad array 427, and a second bonding pad array 428. The wiring patterns 426, the first bonding pad array 427, and the second bonding pad array 428 are formed on the insulating substrate 425. As shown in FIGS. 26A to 26E, for illustrative convenience, only the pair of bumps 424 and the wiring pattern 426 are illustrated. However, in practice, a large number of bumps 424 and wiring patterns 426 are formed on the substrate 425 in correspondence with the bonding pads 424 of the semiconductor element 421.

FIG. 26B is an enlarged view of a bonded portion. Referring to FIG. 26B, the bumps 424 are bonded to the first pad array 427 of the circuit substrate by solid-phase diffusion, thereby constituting a semiconductor device. To repair this semiconductor device, the semiconductor element 421 is removed from the substrate 425. In this case, as shown in FIG. 26C, a crack 429 is formed near the bonding boundary between each barrier layer 423 and the corresponding bump 424. In another destruction mode, as shown in FIG. 26D, a crack 403 is formed near the bonding boundary between each bump 424 and the first pad array 427. For this reason, It is difficult to bond a semiconductor element on the first pad array 427 to obtain electrical and mechanical bonding.

Another semiconductor element 421 is bonded by solid-phase diffusion to the second pad array 428 adjacent to the first pad array 427 from which the semiconductor element was removed, thereby completing repairing the semiconductor device, as shown in FIG. 26E. Solid-phase diffusion bonding can be performed in air or an inert gas atmosphere of $N_2$ gas or the like by a heating method using a heater or a local heating method using a laser beam.

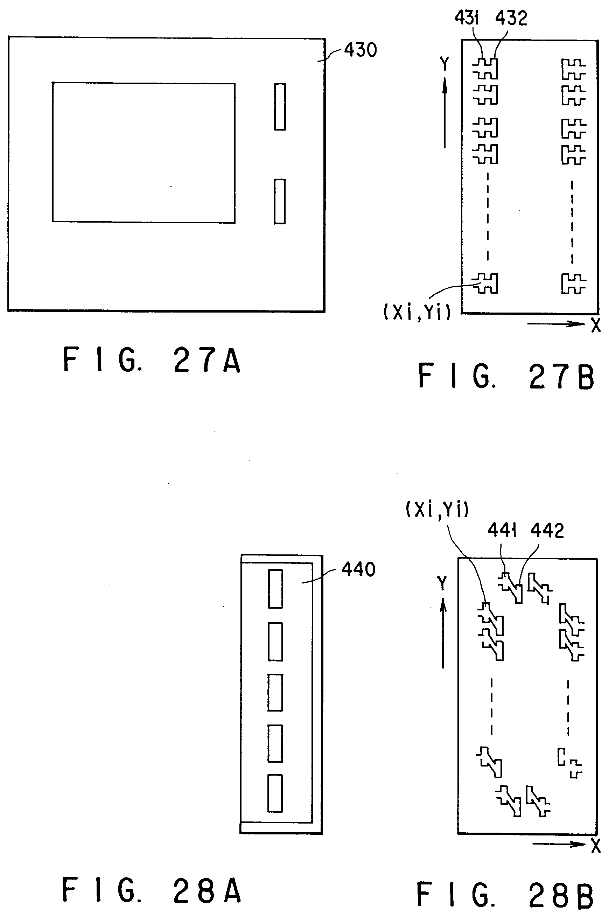

FIGS. 27A and 27B are views for explaining an example of the fifth embodiment of the present invention and show a circuit substrate used for a liquid crystal panel. In this circuit substrate, as shown in FIG. 27A, two-layered wiring patterns each consisting of molybdenum and aluminum are formed in desired regions on a glass substrate 430, as shown in FIG. 27A. First pad arrays 431 are formed in each Wiring pattern at only two opposite sides, as shown in FIG. 27B. Second pad arrays 432 are formed at positions translated from the first pad arrays 431 in the X direction. The first pad array has 26 input pads and 120 output pads per chip of the semiconductor device. The second pad array has 26 input pads and 120 output pads. Thin film transistors, a liquid crystal, polarizing plates, and the like are to be formed on the glass substrate in this wiring substrate.

In the above circuit substrate, the semiconductor chip side is heated to 370°C, the glass substrate side is heated to 80°C, and compression bonding is performed with a load of 15 g/bump for 1.5 sec to connect all the pads at once. The adhesion strength between the semiconductor chip and the glass substrate upon bonding is about 2.0 kg, and no defective connections are formed.

After the above bonding, the semiconductor chip is peeled from the substrate, and the first pad array is cleaned with acetone and a diamond paste. Another semiconductor chip is connected to the second pad array 432 under the same conditions as described above. The adhesion strength upon connection did not change and was kept to be about 2.0 kg. No defective electrical connections were formed.

As described above, repairing can be performed. When the semiconductor chip itself becomes defective, another semiconductor chip can be connected to the second pad array to allow re-mounting. The bonding position is simply translated in the X direction, thereby obtaining connections with excellent reproducibility.

In the above circuit substrate, each bump is made of gold, and each wiring pattern is made of molybdenum and aluminum. However, a combination of such materials is not limited to this. Any combination can be used if materials are subjected to solid-phase diffusion. In addition, homogeneous materials such as a gold bump and a gold wiring layer can be bonded to each other. A plurality of re-mounting bonding pads may be formed.

Another example of the fifth embodiment according to the present invention will be described with reference to FIGS. 28A and 28B.

As shown in FIG. 28A, when a wiring substrate is to be applied to a thermal printer head (TPH), an aluminum thin film is formed on a ceramic substrate 440 by sputtering and patterned by photolithography, thereby obtaining the wiring substrate. The wiring pattern has first pad arrays 41 formed at four sides of the wiring pattern, as shown in FIG. 28B. Second pad arrays 442 are formed at positions obtained by translating the pad arrays 441 in both the X and Y directions. The first pad array has 17 input pads and 140 output pads per chip of the semiconductor element. The second pad array has 17 input pads and 140 output pads per chip.

In the above circuit substrate, the semiconductor chip side is heated to 370°C, the glass substrate side is heated to 60°C, and the semiconductor chip is brought into tight contact with the circuit substrate with a load of 10 g/bump for 2 sec, thereby connecting all the pads at once. The adhesion strength between the semiconductor chip and the glass substrate upon bonding was about 2.0 kg, and no defective electrical connections were formed.

After the above bonding, the semiconductor chip is peeled from the substrate, and the first pad array is cleaned with acetone and a diamond paste. Another semiconductor chip is connected to the second pad array 432 under the same conditions as described above. The adhesion strength upon connection did not change and was kept to be about 2.0 kg. No defective connections were formed.

As described above, repairing can be performed. When the semiconductor chip itself becomes defective, another semiconductor chip can be connected to the second pad array to allow re-mounting. The bonding position is simply translated in the X and Y directions, thereby obtaining connections with excellent reproducibility.

The wiring layer is formed by alternately stacking a plurality of metal layers and a plurality of oxide layers. Peeling occurs between the respective layers. For this reason, the circuit substrate can be repaired twice or more.

Re-mounting bonding pads may be formed on a wiring pattern at predetermined positions, so that a new semiconductor element can be bonded to the re-mounting pads. The present invention can facilitate the repairing operations and realize highly reliable connection.

## Claims

1. An electronic circuit device comprising:
   a substrate (513);
   a wiring layer (514) formed on a surface of said substrate;
   bump-like bonding means (512) formed on said wiring layer; and
   a micro electronic element (511) formed on said bonding means,
   characterized in that solid-phase diffusion bonding is performed either between the wiring layer (514) and the bonding means (512) or between the bonding means (512) and an electrode of the micro electronic element (511).

2. A device according to claim 1, characterized in that said micro electronic element (511) is a package incorporating a semiconductor element.

3. A device according to claim 1, characterized in that said micro electronic element is a passive chip element.

4. A device according to claim 1, characterized in that said micro electronic element (511) is a semiconductor.

5. A device according to claim 1, characterized in that said substrate (513) is a printing head having a ceramic substrate on which a wiring layer is formed.

6. A device according to claim 1, characterized in that said bonding means (512) essentially consists of at least one metal selected from the group consisting of gold, copper, and aluminum.

19

7. A device according to claim 1, characterized in that said wiring layer (514) comprises a wiring pattern essentially consisting of at least one metal selected from the group consisting of gold, copper, tin, and aluminum.

8. A device according to claim 1, characterized in that said wiring layer (514) has a multilayered structure in which a metal layer and an oxide layer of said metal are alternately stacked.

9. A device according to claim 1, characterized in that said wiring layer (426) further comprises a first pad array (427) and a second pad array (428),
said first and second pad arrays (427, 428) being arranged such that a central coordinate position of said second pad array (428) is defined as $(xi+j, yi+k)$ ($i = 1$ to n; i and j are moving distances) when a central coordinate position of said first pad array (427) is defined as $(xi, yi)$ ($i = 1$ to n), and
said bonding means (424) is formed on one of said first and second pad arrays (427, 428).

10. A semiconductor device comprising:
an insulating substrate (13);
a Wiring layer (14) formed on said insulating substrate (13);
bump-like bonding means (B) formed on a surface of said wiring layer (14); and
a semiconductor element (11) formed on said bonding means (12),
characterized in that said bonding layer (14) is bonded to said bonding means (12) by solid-phase diffusion.

11. A device according to claim 10, characterized in that said bonding means essentially consists of at least one metal selected from the group consisting of gold, copper, and aluminum.

12. A device according to claim 10, characterized in that said wiring layer comprises a wiring pattern essentially consisting of at least one metal selected from the group consisting of gold, copper, tin, and aluminum.

13. A device according to claim 10, characterized in that said wiring layer (5) has a multilayered structure in which a metal layer (2) and an oxide layer (3) of said metal are alternately stacked.

14. A device according to claim 9, characterized in that said wiring layer further comprises a first pad array and a second pad array,
said first and second pad arrays being arranged such that a central coordinate position of said second pad array (428) is defined as $(xi+j, yi+k)$ ($i = 1$ to n; i and j are moving distances) when a central coordinate position of said first pad array (427) is defined as $(xi, yi)$ ($i = 1$ to n), and
said bonding means (424) is formed on one of said first and second pad arrays (427, 428).

15. A liquid crystal display device comprising:
first and second substrates opposing each other;
a liquid crystal sandwiched between said first and second substrates;
a wiring layer (82) formed on said first substrate;
bump-like bonding means (83) bonded on the wiring layer; and
a semiconductor element formed on the bonding means (83),
characterized in that said wiring layer (82) includes a top layer having a thickness of 2,500Å to 2500Å and containing aluminum as a main component and has a thickness of 3,000Å to 8,500Å.
said top layer being bonded to said bonding means (83) by solid-phase diffusion.

16. A device according to claim 15, characterized in that said wiring layer (82) comprises a wiring pattern essentially consisting of at least one metal selected from the group consisting of gold, copper, tin, and aluminum.

17. A device according to claim 15, characterized in that said bonding means (83) essentially consists of at least one metal selected from the group consisting of gold, copper, and aluminum.

18. A device according to claim 15, characterized in that said wiring layer (82) has a multilayered structure in which a metal layer and an oxide layer of said metal are alternately stacked.

19. A device according to claim 15, characterized in that said wiring layer (82) further comprises a first pad array and a second pad array,

said first and second pad arrays being arranged such that a central coordinate position of said second pad array is defined as $(x_i + j, y_i + k)$ (i = 1 to n; i and j are moving distances) when a central coordinate position of said first pad array is defined as $(x_i, y_i)$ (i = 1 to n), and

said bonding means is formed on one of said first and second pad arrays.

20. A circuit substrate characterized by comprising a substrate, and a multilayered wiring layer constituted by a first metal layer formed on said substrate, an oxide film formed on said first metal layer and consisting essentially of oxygen the same metal as that of said first metal layer, and a second metal layer formed on said metal oxide film and consisting of a metal as in said first metal layer.

21. A circuit according to claim 20, characterized in that said first and second metal layers essentially consist of at least one metal selected from the group consisting of gold, copper, tin, and aluminum.

22. A circuit substrate characterized by comprising a substrate, a wiring pattern formed on said substrate, and first and second pad arrays formed on said wiring pattern,

characterized in that said first and second pad arrays are defined such that a central coordinate position of said second pad array is defined as $(x_i + j, y_i + k)$ (i = 1 to n; j and k are moving distances) when a central coordinate position of said first pad array is defined as $(x_i, y_i)$ (i = 1 to n).

23. A circuit according to claim 22, characterized in that said wiring pattern essentially consists of at least one metal selected from the group consisting of gold, copper, tin, and aluminum.

24. A printing head comprising:

a substrate;

a wiring layer formed on said first substrate and having a thickness of 3,000Å to 16,000Å said wiring layer including a top layer having a thickness of 2,500Å to 15,500Å and containing aluminum as a main component;

bump-like bonding means bonded on said top layer by solid-phase diffusion; and

a semiconductor element formed on the bonding means.

25. A printing device comprising a printing head comprising:

a substrate;

a Wiring layer formed on said first substrate and having a thickness of 3,000Å to 16,000Å said wiring layer including a top layer having a thickness of 2,500Å to 15,500Å and containing aluminum as a main component;

bump-like bonding means bonded on said top layer by solid-phase diffusion; and

a semiconductor element formed on the bonding means.

FIG 1A

FIG 1B

FIG. 2

FIG. 3

FIG. 4

F I G. 5

F I G. 6 A

F I G. 6 B

F I G. 6 C

F I G. 7

F I G. 8

F I G. 9

F I G. 10

EP 0 615 284 A2

F I G. 1 1

F I G. 1 2

F I G. 1 3

F I G. 1 4

FIG 15

FIG. 16A

FIG. 16B

FIG 16C

FIG. 17

FIG. 18A

FIG. 18B

FIG. 19A

FIG. 19B

FIG 19C

FIG. 20

F I G. 2 1

F I G. 2 2

F I G. 23

F I G. 24

F I G. 25

FIG. 26A

FIG. 26B

FIG. 26C

FIG. 26D

FIG. 26E

FIG. 27A

FIG. 27B

FIG. 28A

FIG. 28B